# EUROPÄISCHE PATENTSCHRIFT

(11) **EP 2 082 636 B1**
(45) Veröffentlichungstag und Bekanntmachung des Hinweises auf die Patenterteilung: **26.05.2010**
(21) Anmeldenummer: 07820904.6
(22) Anmeldetag: 04.10.2007
(51) Int. Cl.: H05K 7/20

(54) **ANTRIEBSEINHEIT, SOWIE VERFAHREN ZUM BETREIBEN EINER ANTRIEBSEINHEIT**
DRIVE UNIT AND METHOD FOR OPERATING A DRIVE UNIT
UNITÉ D'ENTRAINEMENT ET PROCÉDÉ POUR FAIRE FONCTIONNER LADITE UNITÉ D'ENTRAINEMENT

(30) Priorität: 09.10.2006 DE 102006047627
(43) Veröffentlichungstag der Anmeldung: 29.07.2009
(73) Patentinhaber: Robert Bosch GmbH, 70442 Stuttgart (DE)
(72) Erfinder: KRAUTH, Wolfgang, 77855 Achern-Sasbachried (DE); TIMM, Eike, Hermann, 76532 Baden-Baden (DE)
(86) Internationale Anmeldenummer: PCT/EP2007/060527
(87) Internationale Veröffentlichungsnummer: WO 2008/043697

(56) Entgegenhaltungen:
- DE-A1- 4 209 167
- DE-A1- 10 138 711
- DE-A1- 10 239 512
- DE-A1- 19 726 258
- DE-A1-102004 041 027
- US-A- 5 559 673

## Beschreibung

### Stand der Technik

Die Erfindung geht aus von einer Antriebseinheit, sowie einem Verfahren zum Betreiben einer Antriebseinheit nach der Gattung der unabhängigen Ansprüche. Mit der DE-2001022050-A1 ist ein Elektromotor mit einer Elektronikeinheit bekannt geworden, bei der auf einem gemeinsamen Träger sowohl Leistungshalbleiter, als auch elektronische Bauteile zur Ansteuerung des Motors angeordnet sind. Der Nachteil einer solchen Vorrichtung ist, dass alle Bauteile auf dem Träger im Betrieb in gleicher Weise erhitzt werden, sodass die maximale Betriebstemperatur durch das temperaturempfindlichste Bauteil begrenzt ist.

Die DE 197 25 258 A1 zeigt eine Galetteneinheit, bei der innerhalb eines Gehäuses ein Transistor direkt am Kopfteil des Gehäuses angeordnet ist, das an seiner Außenseite Kühlrippen aufweist. An einem thermisch isolierten Bodenteil des Gehäuses ist über Distanzstücke eine Steuerelektronik befestigt, die elektrisch mittels einer Steckverbindung mit dem Transistor kontaktiert ist.

### Offenbarung der Erfindung

### Vorteile der Erfindung

Die erfindungsgemäße Vorrichtung sowie das erfindungsgemäße Verfahren mit den Merkmalen der unabhängigen Ansprüche haben demgegenüber den Vorteil, dass durch die Trennung der Kühlkörper der Leistungselektronik einerseits und der Steuerelektronik andererseits eine Erhitzung der Steuerelektronik durch die Leistungselektronik verhindert wird. Dazu werden die elektrischen Verbindungen zwischen der Leistungselektronik und der Steuerelektronik mittels einer Temperatursenke thermisch weitgehend entkoppelt, sodass auch die notwendige elektrische Verbindung zwischen der Leistungselektronik und der Steuerelektronik letztere nur unwesentlich aufheizt. Dadurch kann die Leistungselektronik mit ihrem Kühlkörper auf höheren Temperaturen betrieben werden als die Steuerelektronik mit ihrem Kühlkörper, wodurch die wärmeempfindlicheren Bauteile weniger belastet werden- Aufgrund der Temperatursenke ist trotz einer thermischen Entkopplung der beiden Kühlkörper eine niederohmige, gut leitende elektrische Verbindung zwischen den separaten Kühlkörpern geschaffen. Um gleichzeitig eine thermische Entkopplung zu realisieren, sind an den elektrischen Leitern Bereiche mit einer großen Oberfläche ausgeformt, die als effektive Temperatursenke dienen. Dabei können diese Bereiche mit vergrößerter Oberfläche ganz gezielt dort angeordnet werden, wo die Wärme gut aus dem Elektronikgehäuse abgeleitet werden kann.

Durch die in den abhängigen Ansprüchen aufgeführten Maßnahmen sind vorteilhafte Weiterbildungen und Verbesserungen der in den unabhängigen Ansprüchen angegebenen Ausführungen möglich. Besonders günstig ist es, die Steuerelektronik räumlich getrennt von der Leistungselektronik zu gruppieren, da aufgrund des räumlichen Abstandes leichter ein Temperaturunterschied zwischen den beiden Elektronik-Gruppen realisiert werden kann. Werden alle Bauelemente der Steuerelektronik und der Leistungselektronik voneinander getrennt, können sich die Steuerelektronik und die Leistungselektronik aufgrund der unterschiedlichen thermischen Belastungsfähigkeit ihrer Bauelemente im Betrieb unterschiedlich stark erwärmen. Wird die Leistungselektronik auf einer metallischen Trägerplatte angeordnet, kann über diese besonders effektiv viel Wärme in kurzer Zeit abgeführt werden.

Durch die thermische Entkopplung der Leistungselektronik und der Steuerelektronik mittels der Temperatursenke kann vorteilhaft ein Temperaturunterschied von 10 bis 40°C erzielt werden, wodurch sich beispielsweise die Leistungselektronik bis 150°C erwärmt, jedoch die Steuerelektronik nur bis 125°C.

Für höhere Leistungen des Antriebs können die elektrischen Leiter zwischen der Leistungselektronik und der Steuerelektronik vorteilhaft als Stanzgitter ausgebildet werden. Das Stanzgitter weist vorteilhaft einen hohen Kupferanteil auf, wodurch eine sehr gute elektrische Kopplung erzielt wird.

Besonders günstig ist es hierzu, die elektrischen Leiter zur Verstärkung der Temperatursenke mit fischer Kühlluft zu versorgen, sodass die Wärmeabgabe im Bereich der erhöhten Oberfläche besonders effektiv ist.

In einer bevorzugten Ausführung wird ein solcher Luftstrom durch die Drehung des Rotors gegenüber dem Stator erzeugt und kann durch die Ausbildung einer entsprechenden Geometrie auf die elektrischen Leiter, vorzugsweise auf deren Bereiche mit vergrößerter Oberfläche, geleitet werden. Dazu können beispielsweise am Rotor oder am Stator oder einem motorisch angetriebenen Lüfterrad Luftleitschaufeln angeordnet werden.

Wird die Elektronikeinheit axial zum Elektromotor angeordnet, kann die Kühlluft besonders einfach radial zwischen dem Elektronikgehäuse und dem Motorgehäuse angesaugt werden und anschließend axial durch den Elektromotor geleitet werden, um dessen elektrische Wicklungen zu kühlen.

Dabei kann der Kühlstrom sehr gezielt derart gelenkt werden, dass die frisch angesaugte Luft zuerst die elektrische Verbindung zwischen der Leistungselektronik und der Steuerelektronik kühlt, und danach die temperaturunempfindlicheren Bereiche, wie die Leistungselektronik und/oder den Elektromotor kühlt. Zur effektiven Kühlung der elektrischen Wicklungen wird die Kühlluft durch axiale Aussparungen in Blechlamellenpaket geführt, in denen auch die elektrischen Wicklungen gewickelt sind.

Besonders günstig kann eine solche Luftführung bei einem elektrisch kommutierten EC-Motor realisiert werden, bei dem der Kern des Elektromotors aus einem Blechlamellenpaket gebildet ist, um den als Rotor ein Außenläufer rotiert. Die Steuerelektronik und die Leistungselektronik sind vorzugsweise gemeinsam in einem Elektronikgehäuse angeordnet, wobei die beiden Kühlkörper innerhalb des Elektronikgehäuses auf einem gemeinsamen Träger angeordnet sind, der die beiden Kühlkörper thermisch entkoppelt. Dabei können beispielsweise die metallischen Kühlkörper direkt auf einem Kunststoffträger befestigt werden, der im Gehäuse angeordnet, oder Teil des Gehäuses ist. Ebenso können die Kühlkörper direkt als Metallträger, beispielsweise als Druckguss-Teil, ausgebildet sein, der ein Teils des Gehäuses bildet.

Zur Ansteuerung des Elektromotors weist die Steuerelektronik intelligente Logik-Bausteine auf, vorzugsweise einen Mikrocontroller oder einen ASIC-Baustein oder eine ICs aufweisende Schaltung. Die Leistungselektronik hingegen weist Leistungshalbleiter-Bauelemente auf, die vom Motorstrom durchflossen werden und sich stärker erwärmen als die Logikbausteine der Steuerelektronik.

Aufgrund der erfindungsgemäßen Führung der Kühlluft kann der Elektromotor bei höheren Umgebungstemperaturen betrieben werden bzw. mit bestehenden elektrischen Bauteilen eine höhere Leistung erzielt werden. Durch die optimale thermische Belastung der einzelnen Bauelemente ist es nicht notwendig, überdimensionierte elektronische Komponenten zu verwenden, wodurch die Antriebseinheit deutlich kostengünstiger gefertigt werden kann.

### Kurze Beschreibungen der Zeichnungen

Ausführungsbeispiele der Erfindung sind in den Zeichnungen dargestellt und in der nachfolgenden Beschreibung näher erläutert. Es zeigen:
- Figur 1: schematisch eine Seitenansicht einer Antriebseinheit und
- Figur 2: eine weitere Antriebseinheit in einer Ansicht von unten.

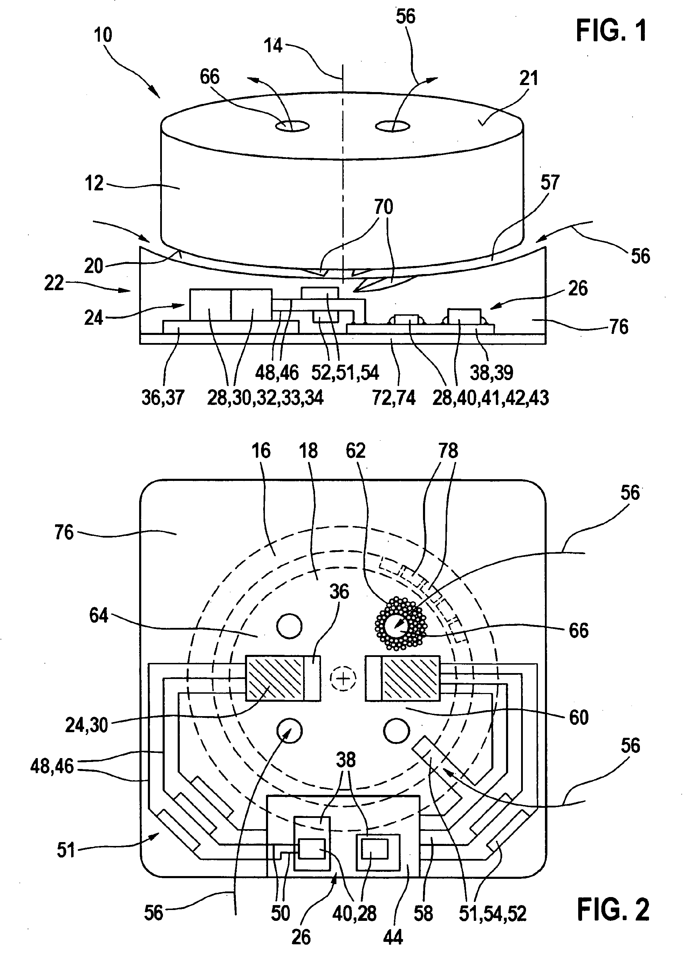

Die in Figur 1 dargestellte Antriebseinheit 10 weist einen Elektromotor 12 auf, bei dem auf einer Rotorachse 14 ein Rotor 16 angeordnet ist, der von einem Stator 18 angetrieben wird. Der Elektromotor 12 ist näherungsweise zylindrisch ausgebildet, wobei an seiner ersten Stirnseite 20 eine Elektronikeinheit 22 angeordnet ist. Die Elektronikeinheit 22 umfasst eine Leistungselektronik 24 und eine Steuerelektronik 26, deren einzelne Bauelemente 28 entsprechend ihrer Temperaturverträglichkeit in getrennte Baugruppen gruppiert sind.

Die Leistungselektronik 24 weist Leistungshalbleiter-Bauelemente 30 auf, die beispielsweise als FET 32 , IGBT 33 oder Bipolar-Transistoren 34 ausgebildet sind. Die Halbleiterbauelemente 30 stehen in direktem Kontakt mit einem ersten Kühlkörper 36, der beispielsweise als Metallplatte 37 ausgebildet ist. Die Steuerelektronik 26 weist als Bauelemente 28 Logikbausteine 40 auf, die beispielsweise als Mikroprozessor 41, ASIC 42 oder ICs 43 ausgebildet sind. Die Bauelemente 38 der Steuerelektronik 26 sind mit mindestens einem zweiten Kühlkörper 38 verbunden. Der zweite Kühlkörper 38 kann ebenfalls als Metallplatte 37 ausgebildet sein oder als gut wärmeleitende Einlegeteile 39 einer Leiterplatte 44. Im Ausführungsbeispiel kann die Leistungselektronik 24 beispielsweise maximal bei einer Temperatur von 150°C betrieben werden, die Steuerelektronik beispielsweise bei maximal 125°C. Um eine unterschiedliche Betriebstemperatur der beiden Baugruppen der Halbleiter-Bauelemente 30 und der Logikbausteine 40 zu gewährleisten, sind die beiden Kühlkörper 36, 38 thermisch voneinander entkoppelt. Hierzu sind die beiden Kühlkörper 36, 38 auch räumlich voneinander getrennt ausgebildet, sodass alle Bauelemente 28 mit einer höheren Temperaturverträglichkeit auf dem ersten Kühlkörper 36 angeordnet sind, und alle Bauelemente 28 mit geringerer Temperaturverträglichkeit auf mindestens einem zweiten (oder mehreren) Kühlkörper 38. Dabei werden die Halbleiterbauelemente 30 mit dem Motorstrom belastet, der höher ist als der Strom, der durch die Logikbausteine 40 der Steuerelektronik 26 fließt. Die Leistungselektronik 24 ist mittels elektrischer Leiter 46 mit der Steuerelektronik 26 verbunden, wobei die elektrischen Leiter 46 beispielsweise als Stanzgitter 48 ausgebildet sind, oder als Leiterbahnen 50 auf der Leiterplatte 44, die einen größeren Querschnitt aufweisen, als entsprechende Leiterbahnen für die Logikbausteine 40.

Um einen Wärmeeintrag durch die Leistungselektronik 24 auf die Steuerelektronik 26 zu minimieren, weisen die elektrischen Leiter 46 nach einem abschnitt mit einem für die Stromführung notwendigen Querschnitt eine geometrische Aufweitung 52 ihrer Oberfläche auf, um dadurch mehr Wärme an die Umgebung abgeben zu können. Die geometrische Aufweitung 52 ist beispielsweise als Kühlblech 54 ausgebildet, das einstückig mit dem Stanzgitter 48 oder den Leiterbahnen 50 ausgebildet ist. Diese geometrische Aufweitung 52 der elektrischen Leiter 46, benachbart angeordnet zu einem Bereich der elektrischen Leiter 46 mit deutlich geringerem Querschnitt, stellt eine Temperatursenke 51 dar, mittels derer die beiden Kühlkörper 36 und 38 thermisch voneinander entkoppelt sind. Für eine gute Effizienz der Temperatursenke 51 wird gezielt frisch angesaugte Kühlluft 56 auf die elektrischen Leiter 46 zwischen der Leistungselektronik 24 und der Steuerelektronik 26 gerichtet. Die Kühlluft 56 wird beispielsweise durch einen Spalt 57 zwischen der Elektronikeinheit 22 und dem Elektromotor 12 radial angesaugt und auf die elektrischen Leiter 46, sowie die Steuerelektronik 26 gelenkt. Dazu sind beispielsweise die Steuerelektronik 26 und die elektrischen Leiter 46 in radial äußeren Bereichen 58 angeordnet, sodass die radial angesaugte Kühlluft 56 zuerst die elektrische Leiter 46 und die Steuerelektronik 26 umströmt, bevor sie die Leistungselektronik 24 kühlt, die beispielsweise in radial inneren Bereichen 60 angeordnet ist. Die radiale Luftströmung der Kühlluft 56 ist in Figur 2 besonders gut zu erkennen. Nachdem die Kühlluft 56 sowohl die Steuerelektronik 26, als auch die Leistungselektronik 24 umströmt hat, wird sie axial durch den Elektromotor 12 geleitet, um diesen mit der bereits angewärmten Kühlluft 56 ebenfalls zu kühlen. Der Elektromotor 12 ist beispielsweise als elektrisch kommutierter EC-Elektromotor 12 ausgebildet, bei dem elektrische Wicklungen 62 auf dem Stator 18 angeordnet sind, der als Lamellen-Blechpaket 64 ausgebildet ist. Entlang den elektrischen Wicklungen 62 sind im Lamellen-Blechpaket 64 in axialer Richtung Durchtrittsöffnungen 66 ausgebildet, durch die die Kühlluft 56 durchströmt, um die elektrischen Wicklungen 62 abzukühlen. An einer der Elektronikeinheit 22 abgewandten zweiten Stirnseite 21 des Elektromotors 12 ist beispielsweise ein nicht näher dargestellter Ventilator angeordnet, der vom Elektromotor 12 angetrieben wird. In einem solchen Ventilator können gezielt Luftleitelemente 70 angeordnet werden, die das Ansaugen von Kühlluft in den Spalt 57 zwischen der Elektronikeinheit 22 und dem Elektromotor 12 verstärken. Ebenso können an der ersten Stirnseite 20 des Elektromotors 12 oder an der Elektronikeinheit 22 Luftleitelemente 70 angeformt werden, die die Strömung der Kühlluft 56 gezielt auf die elektrische Leiter 56 und/oder die Steuerelektronik 26 richten. Die thermisch getrennten Kühlkörper 36, 38 der Leistungseinheit 24 und der Steuereinheit 26 sind im Ausführungsbeispiel gemäß Figur 1 auf einer gemeinsamen Trägerplatte 72 angeordnet, die die beiden Kühlkörper 36, 38 thermisch voneinander isoliert. Beispielsweise kann die Trägerplatte 72 als Kunststoffteil 74 ausgebildet sein und beispielsweise als Bestandteil eines Gehäuses 76 der Elektronikeinheit 22 ausgebildet sein.

Im Ausführungsbeispiel der Figur 2 ist das Gehäuse 76 der Elektronikeinheit 22 näherungsweise viereckig ausgebildet, sodass dieses radial über den Elektromotor 12 übersteht. Der erste Kühlkörper 36 der Halbleiterbauelemente 30 ist beispielsweise einstückig mit den elektrischen Leitern 46 ausgeführt, das die Leistungselektronik 24 mit der Steuerelektronik 26 verbindet. Dabei weisen die als Stanzgitter 48 ausgebildeten elektrischen Leiter 46 als Temperatursenke 51 zusätzliche Kühlflächen 54 auf, die direkt von der frischen Kühlluft 56 umströmt werden. Die Steuerelektronik 26 ist beispielsweise auf einer Leiterplatte 44 angeordnet, die mit elektrischen Leitern 46 mit der Leistungselektronik verbunden ist.

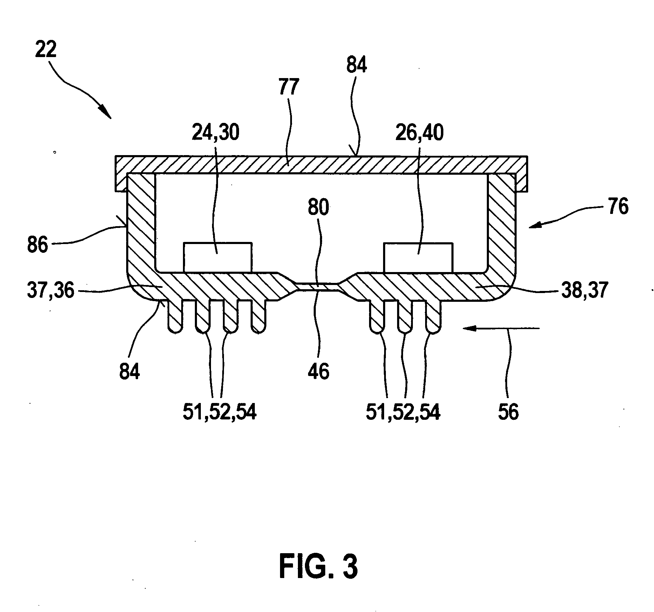

In Figur 3 ist ein weiteres Ausführungsbeispiel einer erfindungsgemäßen Elektronikeinheit 22 dargestellt, bei der die beiden Kühlkörper 36 und 38 einstückig ausgebildet sind. Dabei sind die Kühlkörper 36, 38 beispielsweise als Metallplatte 37 ausgebildet, die durch einen dünnwandigeren Bereich 80 in thermisch entkoppelte Kühlkörper 36, 38 unterteilt ist. Die Kühlkörper 36, 38 sind hierbei als Teil des Elektronikgehäuses 22 ausgebildet und können beispielsweise mittels Druck- oder Spritzguss-Verfahren hergestellt werden. Der dünnwandigere Bereich 80 kann mit einer Wandstärke von weniger als 1,0 mm ausgebildet werden, wobei vorzugsweise Aluminiumguss verwendet wird. Dabei stellt der dünnwandige Bereich 80 gleichzeitig den elektrischen Leiter 46 mit einem geringen Querschnitt dar, der die Leistungselektronik 24 mit der Steuerelektronik 26 elektrisch verbindet. Durch die zusätzliche Ausbildung einer Temperatursenke 51 in Form von Kühlrippen 82 an den beiden Kühlkörpern 36 und 38 können diese thermisch voneinander entkoppelt werden. Der geringere Querschnitt des elektrischen Leiters 46 begrenzt den Wärmefluss vom ersten in den zweiten Kühlkörper 36, 38, wobei die sich daran anschließende geometrische Aufweitung 52 in Verbindung mit der Kühlluft 56 die Abfuhr der reduzierten übertragenen Wärme bewirkt. Die Kühlluft 56 strömt zuerst über die temperaturempfindlicheren Bereich der Steuerelektronik 26, anschließend über den dünnwandigeren Bereich 80 des elektrischen Leiters 46 und danach über den temperaturunempfindlicheren Bereich der Leistungselektronik 24. Als zusätzliche Kühlung kann das Gehäuse 76 der Elektronikeinheit 22 mit einem Metalldeckel 77 verschlossen werden, der beispielsweise als Tiefziehteil hergestellt ist. Das Elektronikgehäuse 22 kann an einer seiner Stirnflächen 84 oder an einer Umfangsfläche 86 mit dem Elektromotor 12 verbunden werden. Aufgrund der räumlichen Trennung der Bauelemente 28 der Steuereinheit 26 von denen der Leistungseinheit 24, kann die konstruktive thermische Trennung der beiden Kühlkörper 36, 38 realisiert werden.

In einer alternativen Ausführung können auch die Halbleiter-Bauelemente 30 auf der thermisch isolierenden Leiterplatte 44 angeordnet werden, wobei die Leistungselektronik 24 dann mittels der elektrischen Leiter 46 mit der Steuerelektronik 26 verbunden ist, die als zusätzliche auf der Leiterplatte 44 angeordnete Leiterbahnen 50 ausgebildet sind. Diese Leiterbahnen 50 weisen ebenfalls eine Temperatursenke 51 auf, um die Leistungselektronik 24 von der Steuerelektronik 26 thermisch zu entkoppeln. In der Ausführung gemäß Figur 2 umströmt die angesaugte Kühlluft 56 zuerst den elektrischen Leiter 46 und die Steuerelektronik 26, sodass die wärmeempfindlichsten Bereiche von der kältesten Kühlluft 56 zuerst umströmt werden. Die vorgewärmte Kühlluft 56 kühlt anschließend die Leistungselektronik 24 und danach die elektrischen Wicklungen 62 des Elektromotors 12, sodass durch die Strömung die vom Elektromotor 12 abgegebene Wärme von der Elektronikeinheit 22 ferngehalten wird. Der Rotor 16 des Elektromotors 12 ist als Außenläufer ausgebildet, der Permanentmagneten 78 aufweist, die durch die elektrisch kommutierten Wicklungen 62 in Rotation versetzt werden. Durch die Rotation des Rotors 16 gegenüber dem Stator 18 kann ein Luftzug erzeugt werden, der die Kühlluft 56 über die zwischen der Leistungselektronik 24 und der Steuerelektronik 26 angeordneten elektrischen Leiter 46 in dem Elektromotor 12 ansaugt.

Es sei angemerkt, dass hinsichtlich der in den Figuren in der Beschreibung dargestellten Ausführungsbeispiele vielfältige Kombinationsmöglichkeiten der einzelnen Merkmale untereinander möglich sind. So kann beispielsweise die Ausbildung und auch die Anzahl der Kühlkörper 36, 38 entsprechend den Anforderungen angepasst werden. Beispielsweise können auch mehrere einzelne Kühlkörper den einzelnen Bauelementen 28 zugeordnet werden, die beispielsweise als Einlegeteile in einen Kunststoffteil 74 ausgebildet sind. Ebenso können die elektrischen Leiter 46 mit reduziertem Querschnitt und deren daran anschließende geometrische Aufweitung 52 zur Ausbildung einer Temperatursenke 51 entsprechend variiert werden. Entscheidend ist, dass durch die erfindungsgemäße Anordnung der Steuerelektronik 26 und der Leistungselektronik 24 und der dazwischen liegenden Temperatursenke 51 unterschiedliche Betriebstemperaturen der Steuerelektronik 26 gegenüber der Leistungselektronik 24 realisiert werden können. Die erfindungsgemäße Vorrichtung findet vorzugsweise Verwendung für Lüftermotoren, kann aber auch für andere Komfortantriebe, beispielsweise für verstellbare Teile im Kraftfahrzeug oder beliebigen anderen Antrieben verwendet werden.

## Patentansprüche

1. Antriebseinheit (10), insbesondere für bewegliche Teile im Kraftfahrzeug, mit einem Elektromotor (12) und einer Elektronikeinheit (22), die eine Steuerelektronik (26) und eine Leistungselektronik (24) umfasst, wobei die Steuerelektronik (26) mit einem ersten Kühlkörper (36) verbunden ist und die Leistungselektronik (24)mit einem zweiten, thermisch getrennten Kühlkörper (38) verbunden ist, und die Steuerelektronik (26) und die Leistungselektronik (24) mittels elektrischer Leiter (46) miteinander verbunden sind, wobei an den elektrischen Leitern (46) eine Temperatursenke (51) angeordnet ist, um die beiden Kühlkörper (36, 38) thermisch zu entkoppeln, **dadurch gekennzeichnet, dass** die Temperatursenke (51) als geometrische Aufweitung (52) der Oberfläche der elektrischen Leiter (46) ausgebildet ist, die sich an einen Bereich mit geringerem Querschnitt anschließt.

2. Antriebseinheit (10) nach Anspruch 1, **dadurch gekennzeichnet, dass** die Steuerelektronik (26) räumlich beabstandet zur Leistungselektronik (24) angeordnet ist, welche insbesondere auf einer Metallplatte angeordnet ist.

3. Antriebseinheit (10) nach einem der Ansprüche 1 oder 2, **dadurch gekennzeichnet, dass** die beiden Kühlkörper (36, 38) im Betriebszustand der Antriebseinheit (10) unterschiedliche Temperaturen haben, insbesondere eine Temperaturdifferenz von etwa 10 bis 40°C aufweisen.

4. Antriebseinheit (10) nach einem der vorhergehenden Ansprüche, **dadurch gekennzeichnet, dass** die elektrischen Leiter (46) als metallisches Stanzgitter (48) oder als dünnwandiger Bereich (80) einer Metallplatte (37) - insbesondere aus Aluminiumguss - ausgebildet sind.

5. Antriebseinheit (10) nach einem der vorhergehenden Ansprüche, **dadurch gekennzeichnet, dass,** die geometrische Aufweitung (52) als Kühlblech (54) ausgebildet ist, das einstückig mit dem Stanzgitter (48) oder mit als Leiterbahnen (50) gebildeten elektrischen Leitern (46) ausgebildet ist.

6. Antriebseinheit (10) nach einem der vorhergehenden Ansprüche, **dadurch gekennzeichnet, dass** die Temperatursenke (51) als Luftstrom (56) ausgebildet ist, der die elektrischen Leiter (46) umströmt.

7. Antriebseinheit (10) nach einem der vorhergehenden Ansprüche, **dadurch gekennzeichnet, dass** der Luftstrom (56) durch einen Rotor (16) des Elektromotors (12) erzeugt wird und mittels Luftleitelementen (70) gezielt auf die elektrischen Leiter (46) gelenkt wird.

8. Antriebseinheit (10) nach einem der vorhergehenden Ansprüche, **dadurch gekennzeichnet, dass** der Elektromotor (12) einen Stator (18) und einen Rotor (16) aufweist, die auf einer Rotorachse (14) angeordnet sind und die Elektronikeinheit (22) axial benachbart zum Elektromotor (12) angeordnet ist, und insbesondere der Luftstrom (56) radial angesaugt und axial durch den Elektromotor (12) geleitet wird.

9. Antriebseinheit (10) nach einem der vorhergehenden Ansprüche, **dadurch gekennzeichnet, dass** der angesaugte frische Luftstrom (56) zuerst die elektrischen Leiter (46) umströmt und anschließend elektrische Wicklungen (62) des Elektromotors (12) kühlt, und insbesondere die elektrischen Wicklungen (62) auf einem Blechlamellenpaket (64) angeordnet sind, das axiale Durchtrittsöffnungen (66) für den Luftstrom (56) aufweist.

10. Antriebseinheit (10) nach einem der vorhergehenden Ansprüche, **dadurch gekennzeichnet, dass** der Elektromotor (12) ein elektrisch kommutierter EC-Motor (12) ist, wobei insbesondere der Rotor (16) als Außenläufer ausgebildet ist.

11. Antriebseinheit (10) nach einem der vorhergehenden Ansprüche, **dadurch gekennzeichnet, dass** die beiden Kühlkörper (36, 38) auf einem gemeinsamen thermisch isolierenden Träger (72), beispielsweise aus Kunststoff angeordnet sind, und der Träger (72) vorzugsweise als Teil eines Elektronikgehäuses (76) ausgebildet ist.

12. Antriebseinheit (10) nach einem der vorhergehenden Ansprüche, **dadurch gekennzeichnet, dass** die Steuerelektronik (22) Logikbausteine (40), wie einen Mikrocontroller (41), einen ASIC (42) oder einen IC-Baustein (43) umfasst, und die Leistungselektronik (24) Leistungshalbleiterbauelemente (30), wie einen FET (32), IGBT (33) oder Bipolar-Transistor (34)umfasst.

13. Verfahren zum Betreiben einer Antriebseinheit (10) mit einem Elektromotor (12) und einer Elektronikeinheit (22) nach einem der vorhergehenden Ansprüche, wobei ein Luftstrom (56) zuerst über die temperaturempfindlichsten Bereiche der Elektronikeinheit (22) geführt wird und anschließend der bereits aufgewärmte Luftstrom (56) über die temperaturunempfindlicheren Bereiche der Elektronikeinheit (22) und/oder des Elektromotors (12) geführt wird, wobei insbesondere der Wärmefluss zu den am wenigsten belastbaren Bauelementen (28) minimiert wird.

## Claims

1. Drive unit (10), in particular for movable parts in a motor vehicle, having an electric motor (12) and an electronic unit (22) which comprises control electronics (26) and power electronics (24), **wherein** the control electronics (26) are connected to a first cooling element (36), and the power electronics (24) are connected to a second, thermally isolated cooling element (38), and the control electronics (26) and the power electronics (24) are connected to one another by means of electrical conductors (46), wherein a temperature sink (51), for thermally decoupling the two cooling elements (36, 38), is arranged on the electrical conductors (46), **characterized in that** the temperature sink (51) is embodied as a geometric widening (52) of the surface of the electrical conductors (46), which widening (52) adjoins a region with a relatively small cross section.

2. Drive unit (10) according to Claim 1, **characterized in that** the control electronics (26) are arranged at a spatial distance from the power electronics (24) which are arranged, in particular, on a metal plate.

3. Drive unit (10) according to one of Claims 1 and 2, **characterized in that** the two cooling elements (36, 38) are at different temperatures, in particular have a temperature difference of approximately 10 to 40°C, in the operating state of the drive unit (10).

4. Drive unit (10) according to one of the preceding claims, **characterized in that** the electric conductors (46) are embodied as a metallic punched grill (48) or as a thin-walled region (80) of a metal plate (37), in particular made of cast aluminium.

5. Drive unit (10) according to one of the preceding claims, **characterized in that** the geometric widening (52) is embodied as a cooling baffle (54) which is embodied in one piece with the punched grill (48) or with electric conductors (46) which are formed as conductor tracks (50).

6. Drive unit (10) according to one of the preceding claims, **characterized in that** the temperature sink (51) is embodied as an air stream (56) which flows around the electrical conductors (46).

7. Drive unit (10) according to one of the preceding claims, **characterized in that** the air stream (56) is produced by a rotor (16) of the electric motor (12) and is directed in a targeted fashion onto the electric conductors (46) by means of air-directing elements (70).

8. Drive unit (10) according to one of the preceding claims, **characterized in that** the electric motor (12) has a stator (18) and a rotor (16), which are arranged on a rotor axis (14), and the electronic unit (22) is arranged axially adjacent to the electric motor (12), and in particular the air stream (56) is sucked in radially and directed axially through the electric motor (12).

9. Drive unit (10) according to one of the preceding claims, **characterized in that** the sucked-in fresh air stream (56) firstly flows around the electrical conductors (46) and subsequently cools electrical windings (62) of the electric motor (12), and in particular the electrical windings (62) are arranged on a laminated core (64) which has axial through-openings (66) for the air stream (56).

10. Drive unit (10) according to one of the preceding claims, **characterized in that** the electric motor (12) is an electrically commutated EC motor (12), wherein in particular the rotor (16) is embodied as an external rotor.

11. Drive unit (10) according to one of the preceding claims, **characterized in that** the two cooling elements (36, 38) are arranged on a common, thermally insulating carrier (72), for example made of plastic, and the carrier (72) is preferably embodied as part of an electronics housing (76).

12. Drive unit (10) according to one of the preceding claims, **characterized in that** the control electronics (26) comprise logic modules (40), such as a microcontroller (41), an ASIC (42) or an IC module (43), and the power electronics (24) comprise power semiconductor components (30) such as an FET (32), IGBT (33) or bipolar transistor (34).

13. Method for operating a drive unit (10) having an electric motor (12) and an electronic unit (22) according to one of the preceding claims, wherein an air stream (56) is firstly directed over the most temperature-sensitive regions of the electronic unit (22), and subsequently the air stream (56) which has already warmed up is directed over the areas of the electronic unit (22) and/or of the electric motor (12) which are less sensitive to temperature, wherein in particular the flow of heat to the components (28) which can be loaded the least is minimized.

## Revendications

1. Unité d'entraînement (10), en particulier pour des parties mobiles d'un véhicule automobile, et présentant un moteur électrique (12) et une unité électronique (22) qui comprend une électronique de commande (26) et une électronique de puissance (24),
l'électronique de commande (26) étant reliée à un premier corps de refroidissement (36) et l'électronique de puissance (24) à un deuxième corps de refroidissement (38) thermiquement séparé,
l'électronique de commande (26) et l'électronique de puissance (24) étant reliées l'un à l'autre au moyen de conducteurs électriques (46),
un drain de chaleur (51) étant disposé sur les conducteurs électriques (46) pour découpler thermiquement les deux corps de refroidissement (36, 38),
**caractérisée en ce que**
le drain de chaleur (51) est configuré comme élargissement géométrique (52) de la surface des conducteurs électriques (46), cet élargissement se raccordant à une partie de section transversale plus petite.

2. Unité d'entraînement (10) selon la revendication 1, **caractérisée en ce que** l'électronique de commande (26) est disposée spatialement à distance de l'électronique de puissance (24) qui est disposée en particulier sur une plaque métallique.

3. Unité d'entraînement (10) selon l'une des revendications 1 ou 2, **caractérisée en ce que** lorsque l'unité d'entraînement (10) est en fonctionnement, les deux corps de refroidissement (36, 38) ont des températures différentes et présentent en particulier une différence de température d'environ 10 à 40°C.

4. Unité d'entraînement (10) selon l'une des revendications précédentes, **caractérisée en ce que** les conducteurs électriques (46) sont configurés sous la forme d'une grille métallique estampée (48) ou d'une partie (80) à paroi mince d'une plaque métallique (37), en particulier en fonte d'aluminium.

5. Unité d'entraînement (10) selon l'une des revendications précédentes, **caractérisée en ce que** l'élargissement géométrique (52) est configuré comme tôle de refroidissement (54) configurée d'un seul tenant avec la grille estampée (48) ou avec les conducteurs électriques (46) configurés sous la forme de pistes conductrices (50).

6. Unité d'entraînement (10) selon l'une des revendications précédentes, **caractérisée en ce que** le drain de chaleur (51) est configuré sous la forme d'un écoulement d'air (56) qui balaie les conducteurs électriques (46).

7. Unité d'entraînement (10) selon l'une des revendications précédentes, **caractérisée en ce que** l'écoulement d'air (56) est produit par le rotor (16) d'un moteur électrique (12) et est envoyé de manière contrôlée sur les conducteurs électriques (46) au moyen d'éléments (70) de guidage d'air.

8. Unité d'entraînement (10) selon l'une des revendications précédentes, **caractérisée en ce que** le moteur électrique (12) présente un stator (18) et un rotor (16) disposés sur un axe (14) de rotor et **en ce que** l'unité électronique (22) est disposée au voisinage axial du moteur électrique (12), et **en ce qu'**en particulier l'écoulement d'air (56) est aspiré radialement et guidé axialement dans le moteur électrique (12).

9. Unité d'entraînement (10) selon l'une des revendications précédentes, **caractérisée en ce que** l'écoulement d'air frais aspiré (56) balaie d'abord les conducteurs électriques (46) et refroidit ensuite les enroulements électriques (62) du moteur électrique (12) et **en ce que** les enroulements électriques (62) sont disposés sur un empilement (64) de lamelles de tôle qui présente des ouvertures axiales (66) permettant le passage de l'écoulement d'air (56).

10. Unité d'entraînement (10) selon l'une des revendications précédentes, **caractérisée en ce que** le moteur électrique (12) est un moteur EC (12) à commutation électrique, dont le rotor (16) est configuré en particulier comme induit extérieur.

11. Unité d'entraînement (10) selon l'une des revendications précédentes, **caractérisée en ce que** les deux corps de refroidissement (36, 38) sont disposés sur un support (72) commun, thermiquement isolant, par exemple en matière synthétique, et **en ce que** le support (72) est de préférence configuré comme partie d'un boîtier électronique (76).

12. Unité d'entraînement (10) selon l'une des revendications précédentes, **caractérisée en ce que** l'électronique de commande (26) comporte des modules logiques (40), par exemple un microcontrôleur (41), un ASIC (42) ou un module IC (43) et **en ce que** l'électronique de puissance (24) comprend des composants semi-électroniques de puissance (30), par exemple un FET (32), un IGBT (33) ou un transistor bipolaire (34).

13. Procédé d'utilisation d'une unité d'entraînement (10) qui présente un moteur électrique (12) et une unité électronique (22) selon l'une des revendications précédentes, dans lequel un écoulement d'air (56) est d'abord amené au-dessus des parties de l'unité électronique (22) sensibles à la température et en ce que l'écoulement d'air (56) déjà réchauffé est ensuite amené sur les parties de l'unité électronique (22) et/ou du moteur électrique (12) insensibles à la température et en ce qu'en particulier le flux de chaleur vers les composants (28) les moins chargés est minimisé.
